# EUROPÄISCHE PATENTSCHRIFT

(11) **EP 1 596 204 B1**
(45) Veröffentlichungstag und Bekanntmachung des Hinweises auf die Patenterteilung: **14.06.2017**
(21) Anmeldenummer: 05008317.9
(22) Anmeldetag: 15.04.2005
(51) Int. Cl.: G01R 1/073

(54) **Elektrische Prüfeinrichtung**
Electrical Testing Facility
Dispositif d'essai électrique

(30) Priorität: 14.05.2004 DE 102004023987
(43) Veröffentlichungstag der Anmeldung: 16.11.2005
(73) Patentinhaber: Feinmetall GmbH, 71083 Herrenberg (DE)
(72) Erfinder: Böhm, Gunther, 71154 Nufringen (DE)
(74) Vertreter: Grosse, Rainer

(56) Entgegenhaltungen:
- EP-A- 1 416 285
- WO-A-02/061443
- US-A- 5 521 523
- US-A- 5 691 651
- US-A- 6 064 215
- US-A1- 2001 026 167
- US-A1- 2002 057 099
- PATENT ABSTRACTS OF JAPAN Bd. 2000, Nr. 13, 5. Februar 2001 (2001-02-05) -& JP 2000 292443 A (SONY CORP), 20. Oktober 2000 (2000-10-20)

## Beschreibung

Die Erfindung betrifft eine elektrische Prüfeinrichtung, insbesondere zur Prüfung von Wafern, mit einem dem Prüfling zuzuordnenden, mit eine Kontaktstiftanordnung bildenden, stiftförmigen Kontaktelementen versehenen Kontaktkopf und mit einer elektrischen Anschlussvorrichtung, die Kontaktflächen aufweist, die mit den, dem Prüfling abgewandten Enden der Kontaktelemente in Berührungskontakt stehen.

Elektrische Prüfeinrichtungen der eingangs genannten Art dienen dazu, einen Prüfling elektrisch zu kontaktieren, um seine Funktionsfähigkeit zu testen. Die elektrische Prüfeinrichtung stellt elektrische Verbindungen zum Prüfling her, das heißt, sie kontaktiert einerseits elektrische Anschlüsse des Prüflings und stellt andererseits elektrische Kontakte zur Verfügung, die mit einem Prüfsystem verbunden werden, das über die Prüfeinrichtung dem Prüfling elektrische Signale zuführt, um für eine Funktionsprüfung beispielsweise Widerstandsmessungen, Strom- und Spannungsmessungen und so weiter durchzuführen. Da es sich bei dem elektrischen Prüfling oftmals um extrem kleine elektronische Bauelemente handelt, beispielsweise um Wafer, aus denen elektronische Bauelemente gefertigt werden, besitzen die stiftförmigen Kontaktelemente des Kontaktkopfes extrem kleine Abmessungen. Um nun eine Anschlussmöglichkeit zum erwähnten Prüfsystem zu schaffen, stehen die Kontaktelemente des Prüfkopfs in Berührungskontakt mit einer Anschlussvorrichtung, die eine Umsetzung auf einen größeren Kontaktabstand vornimmt und insofern das Anschließen von elektrischen Verbindungskabeln ermöglicht, die zum Prüfsystem führen. Da bei der Prüfung unterschiedliche Raumtemperaturen vorliegen können und vorzugsweise die Prüfung auch bei unterschiedlichen Prüflingstemperaturen durchgeführt wird, um seine Funktion auch innerhalb eines bestimmten Temperaturbereichs prüfen zu können, besteht bei den bekannten elektrischen Prüfeinrichtungen die Gefahr, dass aufgrund von thermisch bedingten Längenänderungen eine Kontaktgabe zwischen den Kontaktelementen und den zugeordneten Kontaktflächen der Anschlussvorrichtung nicht immer aufgrund von entstehenden Positionsfehlern einwandfrei gewährleistet ist. Diese Positionsverschiebungen resultieren aus unterschiedlichen Temperaturausdehnungskoeffizienten der verwendeten Materialien, wobei es aus konstruktiven Gründen erforderlich ist, bestimmte Materialien einzusetzen, so dass das geschilderte Problem nicht durch die Wahl gleichen Materiales bei Kontaktkopf und Anschlussvorrichtung gelöst werden kann. Auch unterschiedlich starke Erwärmung einzelner Teile führt zu Positionsverschiebungen.

Aus der Patentschrift US-A-5 691 651 ist bereits eine Prüfeinrichtung bekannt, die eine Einrichtung zur Ausrichtung von Kontaktkopf und Anschlussvorrichtung zueinander aufweist, wobei die Einrichtungen im Bereich der Kontaktelemente durch vier über den Umfang gleichmäßig verteilt angeordnete Verbindungsbolzen gebildet wird, von denen einer fest mit Anschlussvorrichtung und Kontaktkopf verbunden ist, und die drei anderen mit Spiel gehalten sind, sodass eine Temperaturausdehnung von dem einen festen Bolzen ausgeht.

Offenlegungsschrift JP-A-2000 292 443 offenbart eine weitere Prüfvorrichtung, bei welcher ein Kontaktkopf und/oder eine Anschlussvorrichtung aus mehreren Elementen zusammengesetzt sind, die jeweils aus Material mit unterschiedlichen Temperaturkoeffizienten gefertigt sind, um ein gezieltes Temperaturausdehnungsverhalten des Kontaktkopfs beziehungsweise der Anschlussvorrichtung zu erhalten, welches gewährleistet, das trotz Temperaturbeaufschlagung die Kontaktelemente korrekt angeordnet sind.

Aus der Offenlegungsschrift EP-A-1 416 285 ist eine weitere elektrische Prüfeinrichtung bekannt, bei welcher eine Verformung der Anschlussvorrichtung in Richtung eines zu prüfenden Substrats, also axial, verhindert werden soll. Die Befestigung soll eine thermische Deformation einer probe card während Hochtemperaturanwendungen in axialer Richtung verhindern.

Aus der Offenlegungsschrift WO-A-02 061 443 ist eine Prüfeinrichtung der gattungsgemäßen Art bekannt, bei welcher in einen Kontaktkopf mehrere längsverschieblich gelagerte Elemente in Form von Kontaktnadeln angeordnet sind, die mit der Anschlussvorrichtung beziehungsweise mit den Kontaktflächen der Anschlussvorrichtung in Berührungskontakt stehen.

Aus der Offenlegungsschrift WO-A-03 040 734 ist außerdem eine Prüfeinrichtung bekannt, bei welcher einem Kontaktkopf (probe card) ein Versteifungsring zugeordnet ist, welcher eine Deformation der probe card verhindern soll. Der Versteifungsring weist dabei radial ausgerichtete Längsschlitze auf, in welchen Schrauben zur Befestigung des Versteifungsrings an der probe card hindurchgeführt sind. Die Längsschlitze erlauben eine radiale Ausdehnung beziehungsweise Verformung, um zu verhindern, dass die probe card bei Temperaturbeaufschlagung verspannt und ihre Planarität verliert.

Der Erfindung liegt daher die Aufgabe zugrunde, eine Prüfeinrichtung der eingangs genannten Art zur Verfügung zu stellen, bei der die erwähnten Probleme nicht auftreten.

Diese Aufgabe wird bei einer elektrischen Prüfeinrichtung der eingangs genannten Art gelöst durch eine, nur radiales Temperaturausdehnungsspiel durch Gleitführungen zulassende Mittenzentriereinrichtung zur zentrischen Ausrichtung von Kontaktkopf und Anschlussvorrichtung zueinander, gemäß den Merkmalen des Anspruchs 1. Die erfindungsgemäße elektrische Prüfeinrichtung, die auch Vertikal-Prüfkarte genannt wird, besitzt somit zwischen Kontaktkopf und Anschlussvorrichtung die Mittenzentriereinrichtung, die sicherstellt, dass durch Temperaturspiel auftretende Längenänderungen nur von dem jeweiligen Zentrum der erwähnten Bauteile ausgehen und jeweils in radialer Richtung aufgrund der dementsprechend gestalteten Gleitführungen vorliegen. Die Zentren von Kontaktkopf und Anschlussvorrichtung liegen einander diametral gegenüber; sie befinden sich insbesondere auf gleicher Mitten-Hochachse der genannten Bauteile. Da somit erfindungsgemäß zwar aufgrund der unterschiedlichen Materialien Längenänderungen durch Temperaturspiel auftreten werden, die sich jedoch durch die erwähnte Mittenzentriereinrichtung in Verbindung mit den radialen Gleitführungen nicht derart groß aufsummieren, dass eine Stirnfläche eines Kontaktelements nicht mehr die zugehörige Kontaktfläche der Anschlussvorrichtung trifft, ist eine sichere Kontaktgabe gewährleistet. Wird keine erfindungsgemäße Ausbildung vorgesehen, so ist die erwähnte Mittenzentrierung nicht sichergestellt und könnte dazu führen, dass beispielsweise Berührungskontaktstellen randseitig liegender Kontaktelemente einwandfrei mittig auf der jeweils zugeordneten Kontaktfläche der Anschlussvorrichtung liegen, dass jedoch -über die diagonale Längserstreckung der gesamten Kontaktstiftanordnung gesehen- die diametral dazu liegenden Kontaktelemente aufgrund der Längenänderungen schon derart weit in ihrer Position relativ zu den zugeordneten Kontaktflächen entfernt liegen, dass die Positionsfehler nur einen elektrischen Randkontakt zulassen oder sogar gar kein Kontakt mehr zustande kommt, weil sie nicht mit ihren Stirnflächen auf die zugeordneten Kontaktflächen treffen, sondern danebenliegen, sich also am Isoliermaterial der Anschlussvorrichtung abstützen.

Erfindungsgemäß ist vorgesehen, dass die Mittenzentriereinrichtung außerhalb der Stiftanordnung angeordnet ist. Diese Ausgestaltung gestattet es, den Bereich der Kontaktstiftanordnung von den Zentriermitteln freizuhalten, so dass das Gebiet um das jeweilige Zentrum von Anschlussvorrichtung und Kontaktkopf ausschließlich für die Aufnahme von stiftförmigen Kontaktelementen zur Verfügung steht und daher die Vielseitigkeit zur Anpassung an unterschiedliche Prüflinge erhalten bleibt.

Erfindungsgemäß weist die Mittenzentriereinrichtung mindestens drei winkelversetzt zueinander angeordnete Gleitführungen auf. Vorzugsweise liegen diese drei Gleitführungen um 120° zueinander winkelversetzt oder die erste der drei Gleitführungen schließt mit der zweiten Gleitführung einen 90° Winkel und die zweite mit der dritten Gleitführung ebenfalls einen 90° Winkel ein, so dass die dritte zur ersten Gleitführung 180° winkelversetzt liegt. Hierdurch ist die Zentrierung eindeutig bestimmt, das heißt, in der Kontaktebene (X-Y-Ebene) kann es nicht zu einem Positionsversatz im Zentrum der Prüfeinrichtung kommen. Insbesondere ist vorgesehen, dass vier Gleitführungen zum Einsatz kommen, die zueinander um 90° winkelversetzt liegen.

Die Erfindung sieht vor, dass jede der Gleitführungen durch einen Vorsprung an der Anschlussvorrichtung und eine den Vorsprung mit radialem Spiel und in Umfangsrichtung spielfrei aufnehmende Vertiefung in dem Kontaktkopf gebildet ist. Jede der Gleitführungen lässt daher eine Verlagerung des Vorsprungs in der Vertiefung nur in einer Richtung zu, wobei es sich bei dieser Richtung um die radiale Richtung handelt, also -ausgehend von dem Zentrum der Prüfeinrichtung- entsprechend jeweils radial nach außen. Quer zur radialen Richtung verläuft -parallel zur Prüfebene- die erwähnte Umfangsrichtung, in der Spielfreiheit besteht, so dass ein Drehversatz zwischen Kontaktkopf und Anschlussvorrichtung ausgeschlossen ist. Senkrecht auf der Prüfebene, also in axialer Richtung, erfolgt bei der Prüfung ein Annähern der Enden der dem Prüfling zugewandten stiftförmigen Kontaktelemente und dem Prüfling, um den Prüfling zu kontaktieren. In dieser Richtung erfolgt ferner ein aufeinander Zubewegen von Kontaktelement und Prüfkopf, um die elektrische Kontaktierung zwischen diesen beiden Bauteilen zu bewerkstelligen.

Insbesondere kann vorgesehen sein, dass der Vorsprung als Profilstift ausgebildet ist. Das Querschnittsprofil des Stiftes ist kreisförmig oder vorzugsweise nicht kreisförmig, sondern abweichend von der Kreisform gestaltet, um im Zusammenspiel mit den Wandungen der Vertiefung die Radialführung zu gewährleisten.

Insbesondere ist die Vertiefung als Durchbruch, bevorzugt als Langloch ausgebildet.

Eine Weiterbildung der Erfindung sieht vor, dass der Vorsprung die Anschlussvorrichtung durchsetzt und sich bis in eine die Anschlussvorrichtung beaufschlagende Abstützvorrichtung erstreckt. Hierbei kann vorgesehen sein, dass der Vorsprung an der Abstützvorrichtung befestigt ist. Dies erfolgt mit dem einen Endbereich des Vorsprungs. Der andere Endbereich des Vorsprungs kann vorzugsweise an dem Kontaktkopf befestigt sein. Um die Anordnung aus Abstützvorrichtung und Kontaktkopf unter Freigabe der Anschlussvorrichtung axial zu trennen oder trennen zu können, weist der Kontaktstift insbesondere eine geteilte Ausbildung auf und besitzt daher im Bereich der Anschlussvorrichtung eine Teilungsfuge. Diese Ausgestaltung ermöglicht es, dass die beiden Abschnitte des Vorsprungs durch die gebildete radiale Gleitführung in Umfangsrichtung spielfrei zueinander ausgerichtet werden, jedoch in radialer Richtung (in Bezug auf das Zentrum der Prüfeinrichtung) Positionsabweichungen aufgrund unterschiedlicher Temperaturkoeffizienten problemlos unter Beibehaltung der vollen Funktionsfähigkeit der elektrischen Prüfeinrichtung einnehmen können. Die Teilungsfuge der beiden Teile des Vorsprungs liegt insbesondere in einer Ebene, die parallel zur Prüfebene verläuft. Eine Weiterbildung der Erfindung sieht vor, dass der Vorsprung beziehungsweise der Profilstift an seiner Mantelfläche zwei, einander diametral gegenüberliegende, parallele, ebene Führungsflächen aufweist, die jeweils parallel zur radialen Richtung der Prüfeinrichtung verlaufen. Unter "radialer Richtung" ist -wie vorstehend bereits erläutert- die jeweilige radiale Richtung -ausgehend vom Zentrum der Prüfeinrichtung- zu verstehen, die parallel zur Prüfebene verläuft.

Es ist vorteilhaft, wenn der Vorsprung allseitig spielfrei in einer Befestigungsvertiefung der Abstützvorrichtung gehalten ist. Handelt es sich bei dem Vorsprung beispielsweise um den erwähnten Profilstift, so ist dieser innerhalb der Befestigungsvertiefung mit seinem einen Endbereich an der Abstützvorrichtung zur Befestigung gehalten. Er ragt mit seinem freien Ende von dem entsprechenden Bauteil weg, um ein anderes Bauteil oder mehrere andere Bauteile, das eine Radialverlagerungen zulassende Vertiefung beziehungsweise die Radialverlagerungen zulassende Vertiefungen aufweist beziehungsweise aufweisen, zur Bildung der radialen Gleitführung zu empfangen.

Insbesondere kann die Vertiefung parallele Vertiefungswandungen aufweisen, zwischen denen die Führungsmittel, insbesondere Führungsflächen des Vorsprungs beziehungsweise Profilstiftes spielfrei beziehungsweise im Wesentlichen spielfrei aufgenommen sind. Sofern die Vertiefung eine Nut oder ein Durchbruch ist, ist die Nut mit parallelen Nutwandungen beziehungsweise der Durchbruch mit parallelen Durchbruchswandungen zur Ausbildung der jeweiligen Radial-Gleitführung ausgestattet. Um die radiale Verlagerungsmöglichkeit bezogen auf das Zentrum zu schaffen, ist die Vertiefung, die Nut beziehungsweise der Durchbruch langlochartig gestaltet.

Insbesondere sind die Wandungen der Vertiefung, Nutwandungen beziehungsweise Durchbruchswandungen jeweils parallel zur radialen Richtung der Prüfeinrichtung verlaufend ausgebildet. Entsprechendes gilt für die parallelen, ebenen Führungsflächen des jeweils zugeordneten Vorsprungs beziehungsweise Profilstifts.

Bevorzugt kann die Anschlussvorrichtung als Leiterplatte ausgebildet sein. Hierbei handelt es sich insbesondere um eine mehrlagige Leiterplatte, das heißt, sie weist Leiterbahnen auf, die in unterschiedlichen Ebenen der Platte liegen. Die Leiterbahnen führen einerseits zu den erwähnten Kontaktflächen, die mit den Kontaktelementen des Prüfkopfes elektrisch zusammenwirken und führen andererseits zu Anschlüssen, die -beispielsweise über Kabelverbindungen- zum Prüfsystem führen.

Als Kontaktelemente kommen insbesondere Kontaktstifte, beispielsweise Federkontaktstifte oder -bei sehr kleinen Abmessungen, wie sie beispielsweise bei der Waferprüfung vorliegen- Knickdrähte zum Einsatz. Die Kontaktelemente sind längsverschieblich im Kontaktkopf gelagert.

Ferner sieht die Erfindung vor, dass der Vorsprung, insbesondere der Profilstift, einen randseitigen Schlitz aufweist, der in eine Öffnung des Kontaktkopf übergeht und dass in Schlitz und Öffnung ein Passelement, insbesondere eine Passleiste, zur axialen Fixierung des Vorsprungs eingeschoben ist. Der Vorsprung wird dadurch axial fixiert, kann jedoch in 90° dazu stehenden Richtungen aufgrund des reibschlüssigen Eingriffes des Passelementes in Schlitz und/oder Öffnung verlagert werden, also eine Radialverlagerung vornehmen, um die erwähnten Temperaturausdehnungen zuzulassen. Die Öffnung geht seitlich von der Vertiefung aus, wobei Schlitz und Öffnung in radialer Richtung orientiert sind.

Die Zeichnungen veranschaulichen die Erfindung anhand von Ausführungsbeispielen und zwar zeigt:
- Figur 1: eine schematische Querschnittsansicht durch eine elektrische Prüfeinrichtung
- Figur 2: eine Draufsicht auf die Prüfeinrichtung der Figur 1 unter Weglassen von nicht für die Erfindung relevanter Teile,
- Figur 3: eine Querschnittsansicht im Bereich einer Gleitführung der Anordnung der Figuren 1 und 2,
- Figur 4: eine elektrische Prüfeinrichtung nach einem weiteren Ausführungsbeispiel und
- Figur 5: eine Querschnittsansicht im Bereich einer Gleitführung nach einem anderen Ausführungsbeispiel.

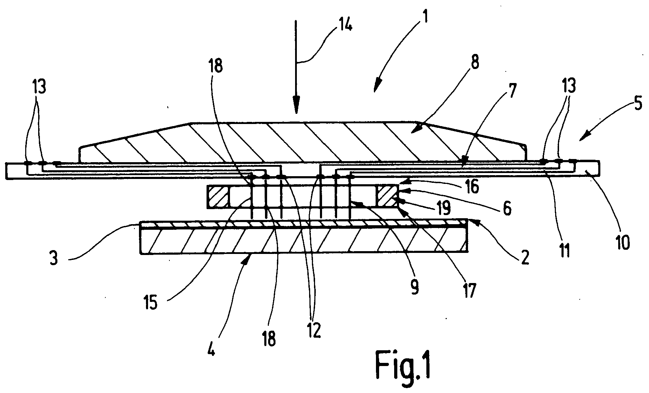

Die Figur 1 zeigt in schematischer Darstellung den Querschnitt durch eine elektrische Prüfeinrichtung 1, die zur Kontaktierung eines Prüflings 2 mittels einer nicht dargestellten elektrischen Kabelverbindung an ein nicht dargestelltes Prüfsystem angeschlossen werden kann, um den Prüfling einer elektrischen Prüfung zu unterziehen. Der Prüfling 2, der als Wafer 3 ausgebildet ist, befindet sich auf einem abstützenden Träger 4, der als Chuck bezeichnet wird und gekühlt oder geheizt werden kann. Auf diese Art und Weise ist es möglich, den Prüfling während der elektrischen Prüfung unterschiedlichen Temperaturen auszusetzen, beispielsweise im Bereich von -50°C bis +200°C, um zu prüfen, ob er in diesem Temperaturbereich einwandfrei arbeitet.

Zur Kontaktierung entsprechender Anschlussstellen des Wafers 3 ist eine Vertikal-Prüfkarte 5 vorgesehen, die die Prüfeinrichtung 1 bildet.

Die Prüfeinrichtung 1 weist einen Kontaktkopf 6 und eine Anschlussvorrichtung 7 auf. Die Anschlussvorrichtung 7 stützt sich an einer Abstützvorrichtung 8 ab. Der Kontaktkopf 6 ist mit einer Vielzahl von längsverschieblich gelagerten Kontaktelementen 9 versehen, die mit ihren einen Endbereichen dem Prüfling 2 und mit ihren anderen Endbereichen der Anschlussvorrichtung 7 zugeordnet sind. Die Anschlussvorrichtung 7 ist als mehrlagige Leiterplatte 10 mit Leiterbahnen 11 ausgebildet, wobei die Leiterbahnen 11 an ihren dem Kontaktkopf 6 zugeordneten Enden Kontaktflächen 12 aufweisen, die den jeweiligen Kontaktelementen 9 zugeordnet sind und an ihren radial außen liegenden Enden elektrische Anschlussflächen 13 besitzen, die über die erwähnten, nicht dargestellten Kabelverbindungen mit dem Prüfsystem (ebenfalls nicht dargestellt) verbindbar sind. Die Anordnung ist derart getroffen, dass die Anschlussvorrichtung 7 eine Umsetzvorrichtung bildet, das heißt, der sehr enge Abstand der winzig kleinen Kontaktflächen 12 (Durchmesser zum Beispiel 50 bis 300 µm) wird über die Leiterbahnen 11 in größere Abstände der Anschlussflächen 13 umgesetzt. Auch haben die Anschlussflächen 13 jeweils eine Größe, um die Kabelverbindungen herstellen zu können.

Bei der Prüfung des Prüflings 2 bewegt sich -abgestützt durch die Abstützvorrichtung 8- die Prüfeinrichtung 1 in axialer Richtung (Pfeil 14) auf den Prüfling 2 zu, sodass die Stirnenden der Kontaktelemente 9 einerseits auf den Wafer 3 und andererseits auf die Kontaktflächen 12 auftreffen. Da die Kontaktelemente 9 als Knickdrähte 15 ausgebildet sind, das heißt in axialer Richtung durch Durchbiegung leicht federnd gestaltet sind, ist eine einwandfreie Kontaktierung möglich.

Der Kontaktkopf 6 besitzt zwei mit Abstand zueinander liegende parallele Keramikplatten 16 und 17, die mit Lagerbohrungen 18 zur Aufnahme der Knickdrähte 15 versehen sind. Die parallele Abstandslage der beiden Keramikplatten 16 und 17 wird mittels eines Abstandshalters 19 realisiert.

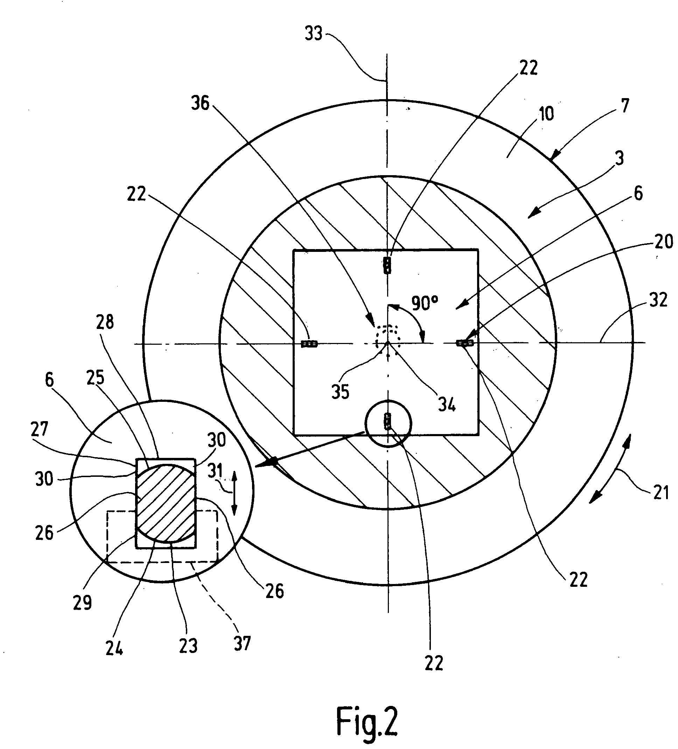

Anstelle einer bisher bekannten starren, festen Verbindung zwischen Kontaktkopf 6 und Anschlussvorrichtung 7 ist erfindungsgemäß eine Mittenzentriereinrichtung 20 zwischen den genannten Bauteilen vorgesehen, die von vier in Umfangsrichtung (Doppelpfeil 21) mit einem Winkelabstand von 90° zueinander versetzt liegenden Gleitführungen 22 gebildet ist, wie dies aus der Figur 2 hervorgeht. Die Figur 2 lässt ferner erkennen, dass der Wafer 3 als Kreisplatte ausgebildet ist. Er weist nicht dargestellte integrierte Schaltkreise auf. Um die Schaltkreise elektrisch zu prüfen, wird der im Grundriss quadratisch ausgebildete Kontaktkopf 6 mit seinen in Figur 2 nicht dargestellten Knickdrähten 15 in verschiedenen Positionen mehrfach auf den Wafer abgesenkt, um jeweils einen entsprechenden Bereich des Wafers 3 prüfen zu können. Die in Figur 2 unten liegende Gleitführung 22 ist vergrößert herausgezeichnet. Sie weist einen Vorsprung 23 in Form eines Profilstiftes 24 auf, der in axialer Richtung (in entgegengesetzter Richtung zu Pfeil 14 in Figur 1) aus dem Kontaktkopf 6 herausragt. Der Profilstift 24 weist an seiner Mantelfläche 25 zwei, einander diametral gegenüberliegende, parallele, ebene Führungsflächen 26 auf. Ferner erstreckt sich der Profilstift 24 mit seinem freien Ende bis in eine Vertiefung 27 hinein, die an der Anschlussvorrichtung 7, also an der Leiterplatte 10, ausgebildet ist. Die Vertiefung 27 ist bevorzugt als Durchbruch 28 der Leiterplatte 10 ausgestaltet. Sie besitzt eine Langlochform, stellt also ein Langloch 29 dar. Die Vertiefung 27 weist zwei parallel zueinander verlaufende Vertiefungswandungen 30 auf, die derart beabstandet zueinander liegen, dass sie die Führungsflächen 26 des Profilstiftes 24 im Wesentlichen spielfrei aufnehmen. Die Längserstreckung des Langlochs 29 ist größer ausgebildet, als die dementsprechende Längsabmessung des Profilstiftes 24, sodass zwischen Kontaktkopf 6 und Anschlussvorrichtung 7, also Leiterplatte 10, gemäß der vergrößerten Darstellung der Figur 2 eine Relativbewegung in Richtung des eingezeichneten Doppelpfeils 31 stattfinden kann. Quer dazu ist eine Relativbewegung nicht möglich, da dies durch die Führung der Führungsflächen 26 an den Vertiefungswandungen 30 verhindert ist.

Aus der Figur 2 wird deutlich, dass die vier Gleitführungen 22 derart angeordnet sind, dass sie auf zwei, sich unter einem Winkel von 90° kreuzenden, gedachten Radialen 32 und 33 liegen, wobei sich die Radialen 32 und 33 in einem Mittelpunkt 34 kreuzen und der Mittelpunkt 34 das Zentrum 35 der Prüfeinrichtung 1 und auch des zu prüfenden Bereichs des Prüflings 2 bildet. Um das Zentrum 35 sind die Knickdrähte 15 angeordnet, die eine Kontaktstiftanordnung 36 bilden. Die vier Gleitführungen 22 befinden sich radial außen liegend zur Kontaktstiftanordnung 36, wobei die Längserstreckungen der Langlöcher 29 derart orientiert sind, dass sie jeweils mittig auf den Radialen 32 und 33 liegen. Entsprechend der Langlochausrichtung der Langlöcher 29 sind die Führungsflächen 26 der einzelnen Profilstifte 24 ausgestaltet.

Aus alledem wird deutlich, dass bei einer durch Temperaturbeaufschlagung entstehenden Materialausdehnung beziehungsweise Materialschrumpfung die Bauteile Kontaktkopf 6 und Anschlussvorrichtung 7 aufgrund der Mittenzentriereinrichtung 20 im Bereich des Zentrums 35 zueinander fixiert sind und Relativbewegungen nur in Richtung der Radialen 32 und 33 erfolgen können. Hierdurch ist sichergestellt, dass die erwähnten Längenänderungen, die aus unterschiedlichen Temperaturausdehnungskoeffizienten der verwendeten Materialien der Bauteile resultieren, nicht dazu führen können, dass derart große Versatzstrecken auftreten, dass die der Leiterplatte 10 zugeordneten Stirnenden der Knickdrähte 15 nicht mehr auf die Kontaktflächen 12 treffen. Die Mittenzentrierung aufgrund der Mittenzentriereinrichtung 20 verhindert derart große Versatzstrecken, da die auftretenden Längenveränderungen vom Zentrum ausgehend beginnen und somit symmetrisch zur Mitte liegen und damit -in radialer Richtung gesehen- nur halb so groß sind, wie ein Versatz, der -bei Nichtverwendung der Erfindung- auftreten könnte, wenn außenliegende Knickdrähte 15 zentral auf die zugeordneten Kontaktflächen 12 aufsetzen, sodass die diametral gegenüberliegenden, ebenfalls außen liegenden Knickdrähte 15 aufgrund der sich aufsummierenden Längenausdehnungen beziehungsweise Längenschrumpfung zu Fehlkontakten führen.

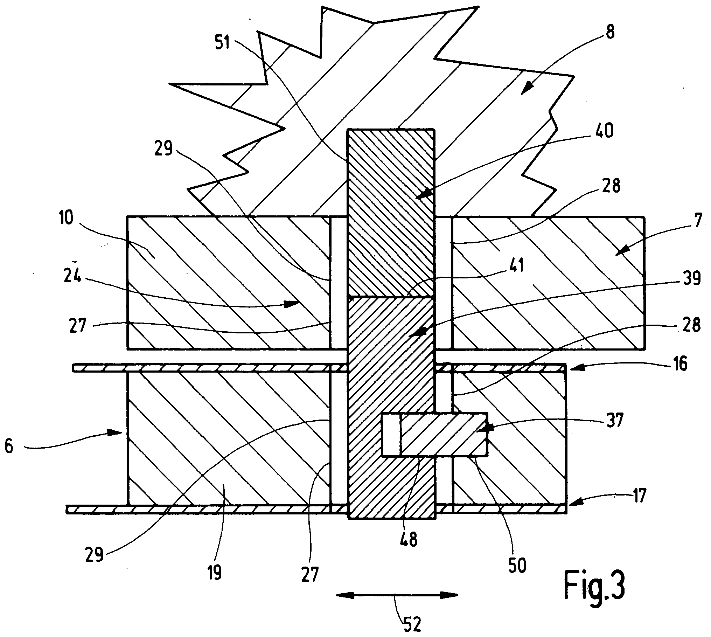

Gemäß Figur 3 ist erkennbar, dass der jeweilige Profilstift 24 mittels einer Passleiste 37 axial in dem Abstandshalter 19 innerhalb der Vertiefung 27 gehalten ist. Selbstverständlich sind auch andere Befestigungsarten möglich, die die Temperaturausdehnungen in radialer Richtung zulassen und eine axiale Fixierung ermöglichen. Ferner zeigt die Figur 3 eine Variante der Profilstiftausbildung gegenüber der Ausgestaltung der Figur 2. Diese besteht darin, dass der Profilstift 24 zweiteilig ausgebildet ist, das heißt, er besteht aus einem ersten Stiftteil 39, der am Kontaktkopf 6 befestigt ist und aus einem zweiten Stiftteil 40, der an der Abstützvorrichtung 8 befestigt ist. Zwischen den beiden Stiftteilen 39 und 40 ist -in dem aus der Figur 3 hervorgehenden Zustand- eine Teilungsfuge 41 ausgebildet, die im Bereich der Anschlussvorrichtung 7, also der Leiterplatte 10 liegt. Die Profilierung der beiden Stiftteile 39 und 40 entspricht der Profilierung, so wie sie aus dem vergrößerten Bereich der Figur 2 hervorgeht. Dies gilt entsprechend auch für die Vertiefung 27 in der Leiterplatte 10 und die Vertiefung 27 in dem Kontaktkopf 6. Beide Vertiefungen 27 sind als Druckbrüche 28 und als Langlöcher 29 ausgebildet. Die Langlochrichtungen sind in Figur 3 mittels des Pfeils 52 dargestellt; dies sind radiale Richtungen. Der Stiftteil 39 ist seitlich mit einem Schlitz 48 versehen, zu dem eine seitliche Öffnung 50 des Kontaktkopfs 6 liegt. In Schlitz 48 und Öffnung 50 ist eine Passleiste 37 eingeschoben. Die Öffnung 50 geht von dem Langloch 29 des Kontaktkopfs 6 aus und besitzt eine radiale Richtung (Pfeil 52). Aus alledem wird deutlich, dass die einzelnen Bauteile in axialer Richtung einfach und problemlos auseinandergenommen und wieder zusammengesetzt werden können und dennoch die Mittenzentrierung erfolgt, so wie sie anhand der Figur 2 beschrieben wurde, wobei zusätzlich aufgrund der Stiftteilung unterschiedliche, temperaturbedingte Längenveränderungen zwischen dem Kontaktkopf 6 und der Leiterplatte 10 einerseits und der Abstützvorrichtung 8 und der Leiterplatte 10 andererseits geführt werden. Aufgrund des passleistengeführten Stiftteils 39 kann sich dieser in radialer Richtung innerhalb des Langlochs 29 des Kontaktkopfes 6 und innerhalb des Langlochs 29 der Leiterplatte 10 radial bewegen. Der Stiftteil 40 ist mittels einer Befestigungsvertiefung 51 allseitig spielfrei in der Abstützvorrichtung 8 befestigt, insbesondere eingepresst. Eine Verlagerung in eine Ebene, die parallel zur Prüfebene liegt, ist daher relativ zur Abstützvorrichtung 8 nicht möglich. Aufgrund des Langlochs 29 in der Leiterplatte 10 ist jedoch eine relative Verlagerung in radialer Richtung zwischen Abstützvorrichtung 8 und Leiterplatte 10 möglich. Ferner können sich die beiden Stiftteile 39 und 40 relativ zueinander in radialer Richtung bewegen.

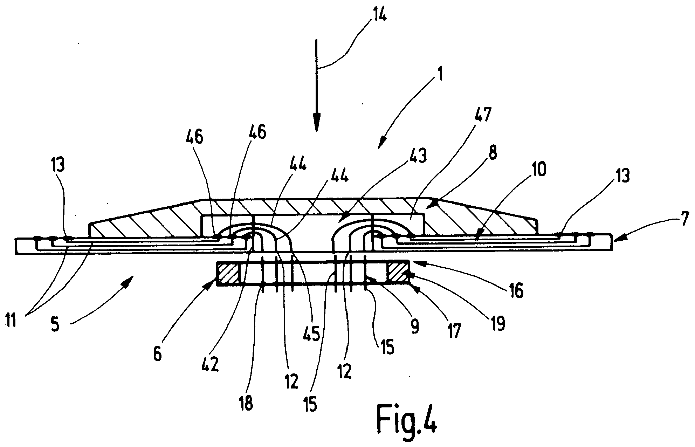

Die Figur 4 zeigt ein weiteres Ausführungsbeispiel einer Prüfeinrichtung, das sich gegenüber dem Ausführungsbeispiel der Figur 1 lediglich dadurch unterscheidet, dass die Leiterplatte 10 eine zentrale Öffnung 42 aufweist, in der ein Gießblock 43 eingebracht ist, in dem elektrische Verbindungsadern 44 eingegossen sind, die mit ihren Stirnflächen 45 die bereits erwähnten Kontaktflächen 12 für die Knickdrähte 15 bilden und deren andere Enden zu Leiterbahnanschlüssen 46 führen, die auf der dem Kontaktkopf 6 abgewandten Seite der Leiterplatte 10 in einer Höhlung 47 der Abstützvorrichtung 8 liegen. Die Verbindung der elektrischen Verbindungsadern 44 mit den Leiterbahnanschlüssen 46 erfolgt vorzugsweise durch Lötung oder Schweißung. Das Ausführungsbeispiel der Figur 4 besitzt selbstverständlich ebenfalls die erfindungsgemäße Mittenzentriereinrichtung 20, die in der Figur 4 jedoch nicht dargestellt ist.

Aus alledem ergibt sich, dass die erfindungsgemäße Vier-Schlitz-Zentrierung der Vertikal-Prüfkarte 5 den Kontaktkopf 6 (Kontakt-Head) und die Anschlussvorrichtung 7 (Anschlusskopf oder Connector) zentral zueinander ausrichten und im Bereich des Zentrums 35 quasi zueinander fixieren. Der Connector wird in der Regel als Leiterplatte ausgebildet, die sich an der Abstützvorrichtung 8 zur Vermeidung von Durchbiegungen und dergleichen abstützt. Diese Abstützvorrichtung 8 wird auch Stiffener genannt und besteht vorzugsweise aus Metall. Wird die Leiterplatte 11 von den Kontaktelementen 9 des Kontaktkopfes 6 direkt kontaktiert, so liegt eine Direct-Attach-Bauform vor (Figur 1). Erfolgt die Kontaktierung über Zwischendrähte, nämlich über die aus der Figur 4 hervorgehenden Verbindungsadern 44, so spricht man von einem verdrahteten Anschlusskopf (Wired Connector). Die am Connector zu kontaktierenden Flächen sind sehr klein. Sie haben typischerweise einen Durchmesser zwischen 50 µm und 300 µm.

Die Prüfung des Prüflings 2 kann sowohl bei Raumtemperatur als auch bei sehr hohen beziehungsweise tiefen Temperaturen erfolgen. Im Falle eines Wafers wird dieser üblicherweise bis auf 200°C aufgeheizt und anschließend bis auf -50°C abgekühlt, um zu prüfen, ob die Funktionen innerhalb dieses Temperaturbereichs gewährleistet sind. Bedingt durch die sehr hohen beziehungsweise sehr tiefen Wafertemperaturen erwärmen sich die Bauteile der Prüfeinrichtung 1 entsprechend oder sie werden dementsprechend abgekühlt. Da -wie erwähnt- die Temperaturausdehnungskoeffizienten der verwendeten Materialien unterschiedlich sind und diese Materialien im Test auch unterschiedliche Temperaturen erreichen, entstehen Positionsfehler der einzelnen Bauteile zueinander, also Positionsverschiebungen von Stiffener, Leiterplatte, Keramikplatten 16, 17, Abstandshalter 19, Wafer 3 und/oder Träger 4. Um die durch diese Temperaturunterschiede entstehenden Positionsfehler zu minimieren und ein ungenügend genaues Treffen der Kontaktelemente zum Connector und/oder der Kontaktelemente zum Wafer zu vermeiden und somit instabile Kontaktierungen nicht aufkommen zu lassen, werden die genannten Bauteile erfindungsgemäß durch die Mittenzentriereinrichtung 20 zueinander zentriert, also nicht fest miteinander verbunden, was zu mechanischen Spannungen und möglicherweise zu Beschädigungen der Bauteile führen könnte.

Aufgrund der Erfindung ist bei einem Ausdehnen der Leiterplatte 11 gewährleistet, dass sich die Mittenposition, also das Zentrum 35 der Leiterplatte nicht verlagert, sondern durch die vier Profilstifte 24 fixiert ist, wobei die Ausdehnung -ausgehend vom Zentrum 35 nach allen vier Richtungen entsprechend der Radialen 32 und 34- gleichmäßig erfolgt. Dieses gilt auch für die anderen Komponenten, nämlich für den Kontaktkopf 6 beziehungsweise für die Abstützvorrichtung 8, sofern sie gemäß der Anordnung der Figur 3 mit in die Mittenzentriereinrichtung 20 einbezogen ist.

Die Erfindung lässt demgemäß eine relative, durch die unterschiedliche Temperaturausdehnung der einzelnen Komponenten verursachte Positionsverlagerung der Bauteile zueinander zu, wobei sie jedoch auf das unvermeintliche Maß reduziert ist und es wird die Mittenposition jeweils beibehalten.

Grundsätzlich können die Vorsprünge 23, also die Profilstifte 24, durch Querschrauben an den jeweiligen Bauteilen befestigt sein. Die Profilstifte 24 können insbesondere mit den quer zu ihren Längsachsen verlaufenden randseitigen Schlitzen 48 versehen sein, mit denen die entsprechenden Öffnungen 50 im Spacer (Abstandshalter 19) fluchten. Die Öffnungen 50 gehen seitlich von den Vertiefungen 27 aus, in die Endbereiche der Profilstifte 24 eingesteckt sind. In die Schlitze 48 und zugeordneten Öffnungen 50 sind gemäß Figur 2 und 3 Passleisten 37 eingeschoben, die die vertikale Lage der Ausrichtstifte (Profilstifte 24) zum Spacer, ohne dass radiale Ausdehnungsbewegungen behindert werden, fixieren. Die Richtungen des Pfeils 31 der Figur 2 entsprechen denen des Pfeils 52 in Figur 3.

Insbesondere ist vorgesehen, dass mindestens drei, beispielsweise vier Ausrichtstifte verwendet werden, wobei eine bevorzugte Ausführungsform auch sechs Ausrichtstifte vorsieht, die gleichmäßig winkelbeabstandet zueinander liegen. Die Ausrichtstifte können im Querschnitt rund, seitlich abgeflacht, rechtwinklig oder dergleichen ausgeführt sein. Es kann vorgesehen sein, dass die Komponenten Führungsplatten (Keramikplatten 16, 17), Spacer und Leiterplatte ohne formschlüssige horizontale Verbindungen am Stiffener montiert sind. Die Komponenten Führungsplatten, Spacer und Leiterplatte können mit den erwähnten Langlöchern versehen sein, um die gewünschte radiale Bewegung bei zentraler Fixierung zu ermöglichen.

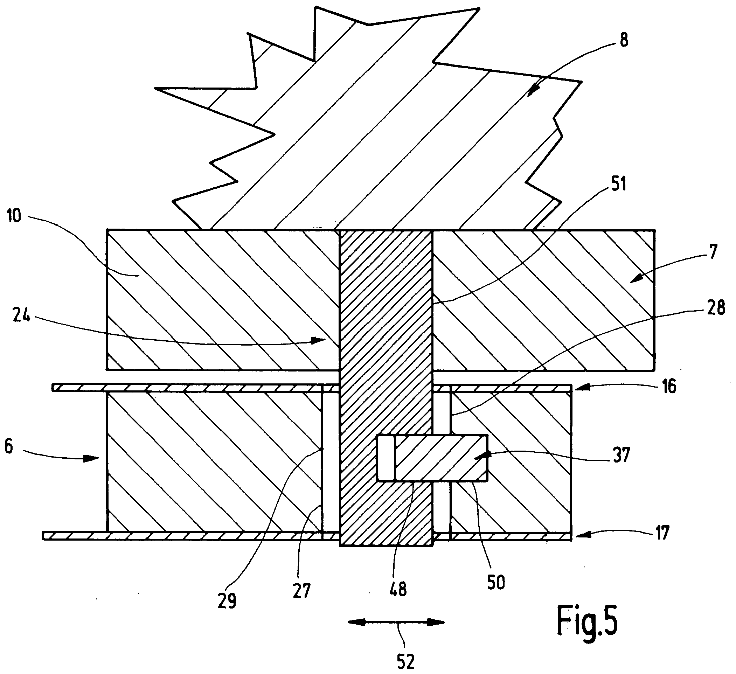

Die Figur 5 zeigt ein weiteres Ausführungsbeispiel einer Prüfeinrichtung 1, das im Wesentlichen dem der Figur 3 entspricht. Nachstehend wird daher nur auf die Unterschiede zu Figur 3 eingegangen. Die Ausführungen in der Figur 3 gelten insoweit beim Ausführungsbeispiel der Figur 5 entsprechend. Unterschiedlich ist, dass es sich bei dem Profilstift 24 um einen einteiligen Stift handelt, das heißt, er besitzt keine Teilungsfuge 41. Ferner ist die Abstützvorrichtung 8 fest mit der Anschlussvorrichtung 7 verbunden, insbesondere verschraubt (in Figur 5 nicht dargestellt). Der Profilstift 24 ist allseitig spielfrei in einer Befestigungsvertiefung 51 der Anschlussvorrichtung 7 befestigt und erstreckt sich demgemäß nicht bis in die Abstützvorrichtung 8. Die übrigen Gegebenheiten entsprechen denen der Figur 3.

## Patentansprüche

1. Elektrische Prüfeinrichtung, insbesondere zur Prüfung von Wafern, mit einem dem Prüfling zuzuordnenden, mit eine Kontaktstiftanordnung bildenden, stiftförmigen Kontaktelementen versehenen Kontaktkopf und mit einer elektrischen Anschlussvorrichtung, die Kontaktflächen aufweist, die mit den, dem Prüfling abgewandten Enden der Kontaktelemente in Berührungskontakt stehen, wobei die Kontaktelemente längsverschieblich im Kontaktkopf gelagert sind, und mit einer, nur radiales Temperaturausdehnungsspiel durch Gleitführungen (22) zulassenden Mittenzentriereinrichtung (20) zur zentralen Ausrichtung von Kontaktkopf (6) und Anschlussvorrichtung (7) zueinander, so dass durch Temperaturspiel auftretende Längenänderungen nur von dem jeweiligen Zentrum von Kontaktkopf (6) und Anschlussvorrichtung (7) radial ausgehen, wobei die Zentren auf der gleichen Mittenhochachse von Kontaktkopf (6) und Anschlussvorrichtung (7) liegen, wobei die Mittenzentriereinrichtung (20) mindestens drei, insbesondere vier, winkelversetzt zueinander angeordnete Gleitführungen (22) aufweist, wobei jede der Gleitführungen (22) durch einen Vorsprung (23) an der Anschlussvorrichtung (7) und eine den Vorsprung (23) mit radialem Spiel und in Umfangsrichtung spielfrei aufnehmende Vertiefung (27) in dem Kontaktkopf (6) gebildet ist, wobei die Mittenzentriereinrichtung (20) außerhalb der Stiftanordnung angeordnet ist, wobei der Vorsprung (23) allseitig spielfrei in einer Befestigungsvertiefung (51) der Anschlussvorrichtung (7) gehalten ist und einen randseitigen Schlitz (48) aufweist, der in eine Öffnung (50) des Kontaktkopf (6) übergeht, wobei die Öffnung (50) seitlich von der Vertiefung (27) ausgeht und Schlitz (48) und Öffnung (50) in radialer Richtung orientiert sind, und wobei in Schlitz (48) und Öffnung (50) ein Passelement, insbesondere eine Passleiste (37), zur axialen Fixierung des Vorsprungs (23) eingeschoben ist.

2. Prüfeinrichtung nach Anspruch 1, **dadurch gekennzeichnet, dass** der Vorsprung (23) ein Profilstift (24) ist.

3. Prüfeinrichtung nach einem der vorhergehenden Ansprüche, **dadurch gekennzeichnet, dass** die Vertiefung (27) ein Durchbruch (28) ist.

4. Prüfeinrichtung nach einem der vorhergehenden Ansprüche, **dadurch gekennzeichnet, dass** die Vertiefung (27) ein Langloch (29) ist.

5. Prüfeinrichtung nach einem der vorhergehenden Ansprüche, **dadurch gekennzeichnet, dass** der Vorsprung (23) beziehungsweise der Profilstift (24) an seiner Mantelfläche (25) Führungsmittel aufweist, insbesondere zwei einander diametral gegenüberliegende, parallele, ebene Führungsflächen (26), die jeweils parallel zur radialen Richtung der Prüfeinrichtung (1) verlaufen.

6. Prüfeinrichtung nach einem der vorhergehenden Ansprüche, **dadurch gekennzeichnet, dass** die Vertiefung (27) parallele Vertiefungswandungen aufweist.

7. Prüfeinrichtung nach einem der vorhergehenden Ansprüche, **dadurch gekennzeichnet, dass** die Vertiefung (27) eine Nut mit parallelen Nutwandungen oder ein Durchbruch mit parallelen Durchbruchswandungen ist.

8. Prüfeinrichtung nach einem der vorhergehenden Ansprüche, **dadurch gekennzeichnet, dass** die Vertiefung (27), die Nut beziehungsweise der Durchbruch langlochartig gestaltet ist.

9. Prüfeinrichtung nach einem der vorhergehenden Ansprüche, **dadurch gekennzeichnet, dass** die Wandungen der Vertiefung (27), Nutwandungen beziehungsweise Durchbruchswandungen jeweils parallel zur radialen Richtung der Prüfeinrichtung (1) verlaufen.

10. Prüfeinrichtung nach einem der vorhergehenden Ansprüche, **dadurch gekennzeichnet, dass** die Anschlussvorrichtung (7) eine Leiterplatte (10) ist.

11. Prüfeinrichtung nach einem der vorhergehenden Ansprüche, **dadurch gekennzeichnet, dass** die Kontaktelemente (9) Kontaktstifte, insbesondere Federkontaktstifte, oder Knickdrähte (15) sind.

12. Prüfeinrichtung nach einem der vorhergehenden Ansprüche, **dadurch gekennzeichnet, dass** die Mittenzentriereinrichtung (20) vier Gleitführungen (22) aufweist, die derart angeordnet sind, dass sie auf zwei, sich unter einem Winkel von 90° kreuzenden, gedachten Radialen (32,33) liegen, die sich in einem Mittelpunkt (34) kreuzen, wobei der Mittelpunkt (34) das Zentrum (35) der Prüfeinrichtung (1) und auch des zu prüfenden Bereichs des Prüflings (2) bildet.

## Claims

1. An electrical test device, in particular for testing wafers, comprising a contact head, which is to be assigned to the test object and which is provided with pin-shaped contact elements, which form a contact pin arrangement, and comprising an electrical connection device, which has contact surfaces, which are in touching contact with the ends of the contact elements facing away from the test object, wherein the contact elements are supported in the contact head in a longitudinally displaceable manner, and comprising a centre centring device (20), which permits only radial temperature expansion play by means of sliding guides (22), so as to centrally orient contact head (6) and connection device (7) relative to one another, so that changes in length appearing as a result of temperature play only emanate radially from the respective centre of contact head (6) and connection device (7), wherein the centres are located on the same centre vertical axis of contact head (6) and connection device (7), wherein the centre centring device (20) has at least three, in particular four sliding guides (22), which are arranged angularly offset with respect to one another, wherein each of the sliding guides (22) is formed by means of a projection (23) on the connection device (7) and a depression (27) in the contact head (6), which accommodates the projection (23) with radial play and in circumferential direction without play, wherein the centre centring device (20) is arranged outside of the pin arrangement, wherein the projection (23) is held in a fastening depression (51) of the connection device (7) without play all-around and has an edge-side slit (48), which transitions into an opening (50) of the contact head (6), wherein the opening (50) starts laterally from the depression (27), and slit (48) and opening (50) are oriented in radial direction, and wherein a fitting element, in particular a fitting strip (37), is inserted into slit (48) and opening (50) for axially fixing the protrusion (23).

2. The test device according to claim 1, **characterized in that** the protrusion (23) is a profile pin (24).

3. The test device according to any one of the preceding claims, **characterized in that** the depression (27) is an aperture (28).

4. The test device according to any one of the preceding claims, **characterized in that** the depression (27) is an elongated hole (29).

5. The test device according to any one of the preceding claims, **characterized in that** the protrusion (23) or the profile pin (24), respectively, has guide means on its jacket surface (25), in particular two parallel, flat guide surfaces (26), which are located diametrically opposite one another and which in each case run parallel to the radial direction of the test device (1).

6. The test device according to any one of the preceding claims, **characterized in that** the depression (27) has parallel depression walls.

7. The test device according to any one of the preceding claims, **characterized in that** the depression (27) is a groove comprising parallel groove walls or an aperture comprising parallel aperture walls.

8. The test device according to any one of the preceding claims, **characterized in that** the depression (27), the groove or the aperture, respectively, is designed in an elongated hole-like manner.

9. The test device according to any one of the preceding claims, **characterized in that** the walls of the depression (27), groove walls or aperture walls, respectively, in each case run parallel to the radial direction of the test device (1).

10. The test device according to any one of the preceding claims, **characterized in that** the connection device (7) is a printed circuit board (10).

11. The test device according to any one of the preceding claims, **characterized in that** the contact elements (9) are contact pins, in particular spring contact pins, or kinked wires (15).

12. The test device according to any one of the preceding claims, **characterized in that** the centre centring device (20) has four sliding guides (22), which are arranged in such a way that they are located on two imaginary radials (32, 33), which intersect one another at an angle of 90°, the radials (32, 33) intersecting one another in a centre point (34), wherein the centre point (34) forms the centre (35) of the test device (1) and also of the area of the test object (2), which is to be tested.

## Revendications

1. Dispositif de test électrique, en particulier pour tester des tranches, comprenant une tête de contact dotée d'éléments de contacts en forme de tige formant un agencement de tiges de contact, attribuée à l'éprouvette, et comprenant un dispositif de raccordement électrique qui présente des faces de contact, qui sont en contact tactile avec les extrémités des éléments de contact détournées de l'éprouvette, dans lequel les éléments de contact sont disposés dans la tête de contact en étant mobiles longitudinalement, et comprenant un dispositif de centrage (20) qui permet un jeu d'expansion de température uniquement radial par des guides coulissants (22), pour l'alignement central de la tête de contact (6) et du dispositif de raccordement (7) entre eux, de sorte que les modifications de longueur survenant du fait du jeu de températures partent radialement uniquement à partir du centre respectif de la tête de contact (6) et du dispositif de raccordement (7), dans lequel les centres reposent sur le même axe supérieur médian de la tête de contact (6) et du dispositif de raccordement (7), dans lequel le dispositif de centrage (20) présente au moins trois, en particulier quatre guides coulissants (22) disposés en étant en décalage angulaire entre eux, dans lequel chaque guide coulissant (22) est formé dans la tête de contact (6) par une saillie (23) sur le dispositif de raccordement (7) et un creux (27) recevant la saillie (23) avec un jeu radial et sans jeu dans le sens périphérique, dans lequel le dispositif de centrage (20) est disposé en-dehors de l'agencement de tiges, dans lequel la saillie (23) est maintenue sans jeu de tous côtés dans un creux de fixation (51) du dispositif de raccordement (7) et présente une fente (48) sur le bord latéral qui passe dans une ouverture (50) de la tête de contact (6), dans lequel l'ouverture (50) part latéralement à partir du creux (27) et, fente (48) et ouverture (50) sont orientées dans le sens radial, et dans lequel un élément d'ajustement, en particulier une baguette d'ajustement (37) pour la fixation axiale de la saillie (23) est poussée à l'intérieur de la fente (48) et de l'ouverture (50).

2. Dispositif de test selon la revendication 1, **caractérisé en ce que** la saillie (23) est une tige profilée (24).

3. Dispositif de test selon l'une des revendications précédentes, **caractérisé en ce que** le creux (27) est une percée (28).

4. Dispositif de test selon l'une des revendications précédentes, **caractérisé en ce que** le creux (27) est un trou oblong (29).

5. Dispositif de test selon l'une des revendications précédentes, **caractérisé en ce que** la saillie (23), respectivement la tige profilée (24), présente des moyens de guidage sur sa surface d'enveloppe (25), en particulier deux surfaces de guidage (26) planes parallèles et diamétralement opposées l'une à l'autre qui sont respectivement parallèles au sens radial du dispositif de test (1).

6. Dispositif de test selon l'une des revendications précédentes, **caractérisé en ce que** le creux (27) présente des parois de creux parallèles.

7. Dispositif de test selon l'une des revendications précédentes, **caractérisé en ce que** le creux (27) est une rainure avec des parois de rainure parallèles ou une percée avec des parois de rainure parallèles.

8. Dispositif de test selon l'une des revendications précédentes, **caractérisé en ce que** le creux (27), la rainure, respectivement, la percée est formé(e) en trou oblong.

9. Dispositif de test selon l'une des revendications précédentes, **caractérisé en ce que** les parois du creux (27), les parois de la rainure, respectivement, les parois de la percée sont respectivement parallèles au sens radial du dispositif de test (1).

10. Dispositif de test selon l'une des revendications précédentes, **caractérisé en ce que** le dispositif de raccordement (7) est un circuit imprimé (10).

11. Dispositif de test selon l'une des revendications précédentes, **caractérisé en ce que** les éléments de contact (9) sont des tiges de contact, en particulier des tiges de contact à ressort, ou des câbles pliés (15).

12. Dispositif de test selon l'une des revendications précédentes, **caractérisé en ce que** le dispositif de centrage (20) présente quatre guides coulissants (22) qui sont ainsi disposés qu'ils reposent sur deux radiales (32, 33) imaginaires sécantes dans un angle de 90°, qui sont sécantes en un point médian (34), dans lequel le point médian (34) forme le centre (35) du dispositif de test (1) et également de la zone à tester de l'éprouvette (2).
